# EUROPEAN PATENT APPLICATION

(11) **EP 4 822 695 A1**
(43) Date of publication of application: **14.10.2026**
(21) Application number: 26166321.5
(22) Date of filing: 20.03.2026
(51) Int. Cl.: G11C 7/06, G11C 11/4091

(54) **BIT LINE SENSE AMPLIFIER AND A MEMORY APPARATUS USING THE SAME**

(30) Priority: 07.04.2025 KR 20250044767
(71) Applicant: SK hynix Inc., Bubal-eub Icheon-si Gyeonggi-do 17336 (KR)
(72) Inventor: KIM, Kwang Soo, 17336 Icheon-si, Gyeonggi-do (KR)
(74) Representative: Isarpatent

(57) **Abstract**

A memory apparatus includes a bit line sense amplifier. The bit line sense amplifier includes an input circuit, a latch circuit, and an isolation switching circuit. The input circuit is configured to change the voltage levels of first and second nodes based on the voltage levels of a first bit line and a second bit line. The latch circuit is configured to change the voltage levels of the first and second nodes based on the voltage levels of the second and first nodes, respectively. The isolation switching circuit is configured to couple the first bit line to the second node based on a first isolation switching signal and to couple the second bit line to the first node based on a second isolation switching signal.

## Description

### BACKGROUND

### 1. Technical Field

Various embodiments relate to a method of designing an integrated circuit, and more particularly, to a bit line sense amplifier and a memory apparatus using the same.

### 2. Related Art

A memory apparatus may include a memory cell array in which data may be stored. A plurality of word lines and a plurality of bit lines are disposed in the memory cell array. A plurality of memory cells may be disposed at points at which the plurality of word lines and the plurality of bit lines cross each other. The memory apparatus includes a bit line sense amplifier, and it may store data in the plurality of memory cells or read data stored in the plurality of memory cells through the bit line sense amplifier. When a word line is enabled, the voltage level of the bit line is changed depending on the type of data stored in the memory cell. The bit line sense amplifier may amplify the voltage level of the bit line by sensing a change in the voltage level of the bit line.

As a semiconductor apparatus is integrated and reduced in size, performance variation of a MOS transistor according to a process skew and a process, voltage, temperature (PVT) variation is increased because it is difficult to control a process of determining characteristics of the MOS transistor. A recent bit line sense amplifier includes a configuration capable of compensating for a mismatch between the differential input transistors of the bit line sense amplifier because a mismatch between the differential input transistors of the bit line sense amplifier may have a great influence on performance of the bit line sense amplifier.

### SUMMARY

In an embodiment, a memory apparatus may include an input circuit, a latch circuit, an isolation switching circuit, and an isolation switching control circuit. The input circuit may be configured to change the voltage level of a first node based on the voltage level of a first bit line and to change the voltage level of a second node based on the voltage level of a second bit line. The latch circuit may be configured to change the voltage level of the second node based on the voltage level of the first node and to change the voltage level of the first node based on the voltage level of the second node. The isolation switching circuit may be configured to couple the first bit line to the second node based on a first isolation switching signal and to couple the second bit line to the first node based on a second isolation switching signal. The isolation switching control circuit may be configured to increase the voltage level of the first isolation switching signal to the voltage level of an isolation voltage and to gradually increase the voltage level of the second isolation switching signal to the voltage level of the isolation voltage, when an isolation switching enable signal is enabled.

In an embodiment, a memory apparatus may include an input circuit, a latch circuit, an isolation switching circuit, and a mismatch compensation circuit. The input circuit may be configured to change the voltage level of a first node based on the voltage level of a first bit line and to change the voltage level of a second node based on the voltage level of a second bit line. The latch circuit may be configured to change the voltage level of the second node based on the voltage level of the first node and to change the voltage level of the first node based on the voltage level of the second node. The isolation switching circuit may be configured to couple the first bit line to the second node based on a first isolation switching signal and to couple the second bit line to the first node based on a second isolation switching signal. The mismatch compensation circuit may be configured to couple the first bit line to the first node based on a first mismatch compensation signal and to couple the second bit line to the second node based on a second mismatch compensation signal.

### BRIEF DESCRIPTION OF THE DRAWINGS

FIG. 1 is a diagram illustrating a configuration of a memory apparatus according to an embodiment.
FIG. 2 is a diagram illustrating a configuration of a memory cell array according to an embodiment.
FIG. 3 is a diagram illustrating a configuration of a memory apparatus and a bit line sense amplifier according to an embodiment.
FIG. 4A is a diagram illustrating a configuration of an isolation switching control circuit illustrated in FIG. 3.
FIG. 4B is a timing diagram illustrating an operation of an isolation switching circuit illustrated in FIG. 4A.
FIG. 5A is a diagram illustrating a configuration of a mismatch compensation control circuit illustrated in FIG. 3.
FIG. 5B is a diagram illustrating a configuration of a delay circuit illustrated in FIG. 5A.
FIG. 6 is a timing diagram illustrating operations of a memory apparatus and a bit line sense amplifier according to an embodiment.

### DETAILED DESCRIPTION

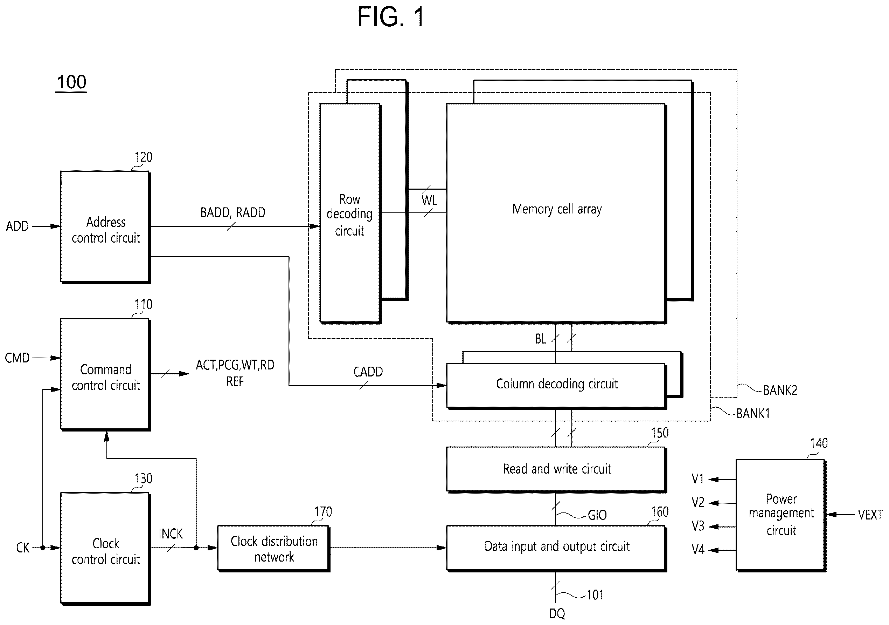

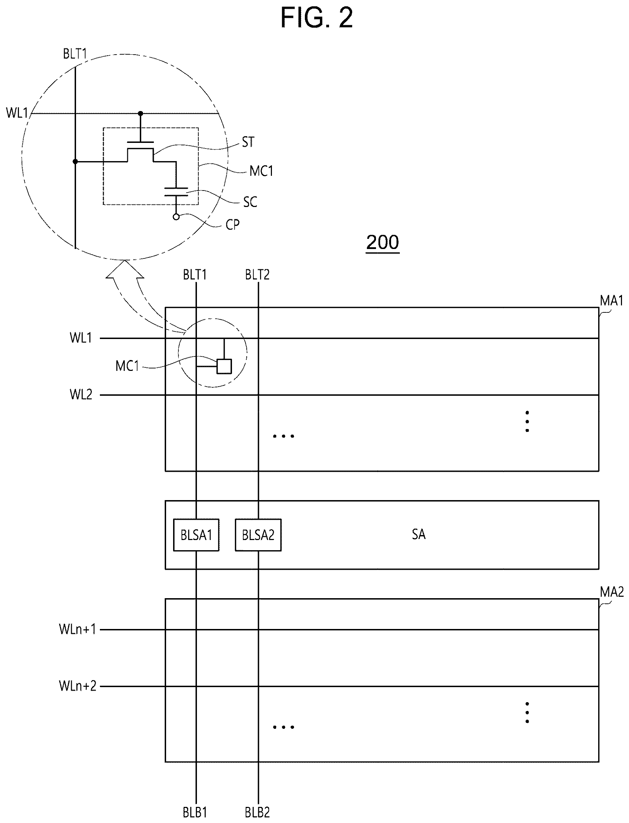

FIG. 1 is a diagram illustrating a configuration of a memory apparatus 100, according to an embodiment. Referring to FIG. 1, the memory apparatus 100 may include a plurality of memory banks BANK1 and BANK2, a command control circuit 110, an address control circuit 120, a clock control circuit 130, a power management circuit 140, a read and write circuit 150, and a data input and output circuit 160. The plurality of memory banks BANK1 and BANK2 may represent a data storage area of the memory apparatus 100. The plurality of memory banks BANK1 and BANK2 may each include a memory cell array, a row decoding circuit, and a column decoding circuit. In FIG. 1, the memory apparatus 100 has been illustrated as including two memory banks, but the number of memory banks included in the memory apparatus 100 may be a multiple of 4 to be 4, 8, 12, or more. The memory cell array may include a plurality of memory cells capable of storing data. The memory cell array includes a plurality of word lines and a plurality of bit lines. A plurality of memory cells may be coupled to the plurality of word lines and the plurality of bit lines, respectively, at points at which the plurality of word lines and the plurality of bit lines cross each other. The memory cell array may include a plurality of unit cell arrays. A unit cell array may be a memory tile or a memory cell mat. A bit line sense amplifier array may be disposed between the plurality of unit cell arrays. The connection of the unit cell array and the bit line sense amplifier array is described later with reference to FIG. 2.

The row decoding circuit may receive a bank address signal BADD and a row address signal RADD. The row decoding circuit may select at least one of the plurality of memory banks by decoding the bank address signal BADD and the row address signal RADD, and the row decoding circuit may enable at least one of the plurality of word lines coupled to the selected memory bank. The column decoding circuit may receive a column address signal CADD. The column decoding circuit may select a bit line pair that is coupled to the read and write circuit 150, among the plurality of bit lines, based on the column address signal CADD. The column decoding circuit may provide a hierarchical connection structure. For example, the column decoding circuit may couple the selected bit line pair to a local input and output line pair based on the column address signal CADD. The selected bit line pair may be coupled to the read and write circuit 150 through the local input and output line pair. The column decoding circuit may include a column switch that couples the bit line pair to the local input and output line pair, and the column decoding circuit may generate a column selection signal that controls the column switch based on the column address signal CADD.

The command control circuit 110 may receive a command signal CMD, and may generate an internal command signal by decoding the command signal CMD. The internal command signal may include an active signal ACT, a precharge signal PCG, a write signal WT, a read signal RD, and a refresh signal REF. The command signal CMD may be a signal that is provided by a host device (not illustrated) that is coupled to the memory apparatus 100. The host device may provide the command signal CMD to the memory apparatus 100 so that the memory apparatus 100 may perform various operations. An operation of outputting data stored in the memory apparatus 100 to the host device may be a read operation. An operation of storing data received from the host device in the memory apparatus 100 may be a write operation. An operation of selecting, by the memory apparatus 100, a specific memory bank before performing the read operation and the write operation and enabling a word line of the memory cell array may be an active operation. An operation of disabling a word line of the memory cell array may be a precharge operation. When the host device provides the command signal CMD that enables the active operation to be performed, the command control circuit 110 may generate the active signal ACT by decoding the command signal CMD. When the host device provides the command signal CMD that enables the precharge operation to be performed, the command control circuit 110 may generate the precharge signal PCG by decoding the command signal CMD. In an embodiment, the command control circuit 110 might not receive the command signal CMD that generates the precharge signal PCG from the host device, and may generate the precharge signal PCG by delaying the active signal ACT. When the host device provides the command signal CMD that enables the write operation to be performed, the command control circuit 110 may generate the write signal WT by decoding the command signal CMD. When the host device provides the command signal CMD that enables the read operation to be performed, the command control circuit 110 may generate the read signal RD by decoding the command signal CMD. The memory apparatus 100 may periodically perform a refresh operation that retains data stored in the memory cell. When the host device provides the command signal CMD that enables the refresh operation to be performed, the command control circuit 110 may generate the refresh signal REF by decoding the command signal CMD. In an embodiment, when the memory apparatus 100 enters a low power mode, the command control circuit 110 may generate refresh signal REF to periodically perform the refresh operation although the command control circuit does not receive the command signal CMD from the host device. The command control circuit 110 may provide the internal command signal to the row decoding circuit, the read and write circuit 150, and the data input and output circuit 160. For example, the command control circuit 110 may provide the active signal ACT, the precharge signal PCG, and the refresh signal REF to the row decoding circuit, and may provide the read signal RD and the write signal WT to the read and write circuit 150 and the data input and output circuit 160.

The address control circuit 120 may receive an address signal ADD, and may generate the bank address signal, the row address signal RADD, and the column address signal CADD based on the address signal ADD. The address signal ADD may be provided from the host device to the memory apparatus 100. The host device may provide the address signal ADD to the memory apparatus 100 to access the plurality of memory banks BANK1 and BANK2 of the memory apparatus 100. The address control circuit 120 may latch the address signal ADD, and the address control circuit 120 may output the latched address signal as the bank address signal BADD and the row address signal RADD or as the column address signal CADD. For example, the address control circuit 120 may output the address signal ADD that is received during an active operation of the memory apparatus 100 as the bank address signal BADD and the row address signal RADD. The address control circuit 120 may output the address signal ADD that is received during one of a read operation and write operation of the memory apparatus 100 as the column address signal CADD.

The clock control circuit 130 may receive the clock signal CK and generate a plurality of internal clock signals INCK based on the clock signal CK. The clock signal CK may be provided from the host device to the memory apparatus 100. The clock control circuit 130 buffers the clock signal CK, and may generate the internal clock signals INCK by performing a delay-locked operation on the clock signal CK. The clock control circuit 130 may include a delay-locked loop circuit capable of performing the delay-locked operation. The clock control circuit 130 may provide the internal clock signals INCK to internal circuits that operate in synchronization with the clock signal, among the internal circuits of the memory apparatus 100. For example, the clock control circuit 130 may provide the internal clock signals INCK to the command control circuit 110. The command control circuit 110 latches the command signal CMD in synchronization with the clock signal CK, and may decode the latched command signal. When receiving the command signal CMD that enables the read operation or the write operation to be performed, the command control circuit 110 may delay the command signal that is decoded by a time corresponding to read latency or write latency in synchronization with the clock signal CK. The command control circuit 110 may output the delayed command signal as the read signal RD or the write signal WT in synchronization with the internal clock signals INCK. Furthermore, the clock control circuit 130 may provide the internal clock signals INCK to the data input and output circuit 160. The memory apparatus 100 may further include a clock distribution network 170. The clock distribution network 170 repeats the internal clock signals INCK received from the clock control circuit 130, and the clock distribution network 170 may distribute the repeated internal clock signals INCK to the data input and output circuit 160.

The power management circuit 140 may receive an external voltage VEXT from a power source and generate a plurality of internal voltages based on the external voltage VEXT. The plurality of internal voltages may have different voltage levels. The power management circuit 140 may include a voltage generation circuit capable of generating the plurality of internal voltages, such as a voltage distribution circuit, a voltage pumping circuit, and a voltage regulator. The power management circuit 140 may distribute the plurality of internal voltages to the internal circuits of the memory apparatus 100 through a voltage mesh (not illustrated) disposed in the memory apparatus 100. The plurality of internal voltages may include a first internal voltage V1, a second internal voltage V2, a third internal voltage V3, and a fourth internal voltage V4. In different embodiments, the number of internal voltages that are generated by the power management circuit 140 may be five or more. For some embodiments, the second internal voltage V2 may have a higher voltage level than the first internal voltage V1. The third internal voltage V3 may have a lower voltage level than the first internal voltage V1. The fourth internal voltage V4 may have a voltage level that is equal to or lower than the voltage level of the first internal voltage V1. The first internal voltage V1 may be a basic source voltage. The second internal voltage V2 may be a pumping voltage. The third internal voltage V3 may be a core voltage. The fourth internal voltage V4 may be a peripheral voltage. The power management circuit 140 may provide the first internal voltage V1 and the third internal voltage V3 to the plurality of memory banks BANK1 and BANK2. The power management circuit 140 may provide the second internal voltage V2 to the row decoding circuit. The power management circuit 140 may provide the first and fourth internal voltages V1 and V4 to the command control circuit 110, the address control circuit 120, the clock control circuit 130, the read and write circuit 150, and the data input and output circuit 160.

The read and write circuit 150 may be coupled to the bit lines of the memory cell array through the column decoding circuit. The read and write circuit 150 may receive the read signal RD and the write signal WT from the command control circuit 110. The read and write circuit 150 may be coupled to the data input and output circuit 160 through a global input and output lines GIO. The read and write circuit 150 may amplify data that are output from the memory cell array through the bit lines based on the read signal RD during a read operation of the memory apparatus 100, and the read and write circuit 150 may output the amplified data to the global input and output lines GIO. The read and write circuit 150 may amplify data that are received through the global input and output lines GIO based on the write signal WT during a write operation of the memory apparatus 100, and may provide the amplified data to the memory cell array through the bit lines BL.

The data input and output circuit 160 may be coupled to the global input and output lines GIO and a data bus 101. The data bus 101 may be a signal transmission line that couples the host device and the memory apparatus 100. The data input and output circuit 160 may receive the read signal RD and the write signal WT from the command control circuit 110, and the data input and output circuit 160 may receive the repeated internal clock signals INCK from the clock control circuit 130 and the clock distribution network 170. The data input and output circuit 160 may receive data that are transmitted through the global input and output lines GIO based on the read signal RD during a read operation of the memory apparatus 100, may generate a data stream DQ based on the received data, and may transmit the data stream DQ to the host device through the data bus 101 in synchronization with the internal clock signals INCK. The data input and output circuit 160 may receive a data stream DQ that is transmitted by the host device through the data bus 101 based on the write signal WT during a write operation of the memory apparatus 100. The data input and output circuit 160 may generate data based on the data stream DQ in synchronization with the internal clock signals INCK, and the data input and output circuit 160 may transmit the data to the read and write circuit 150 through the global input and output lines GIO. The data input and output circuit 160 may include a serializer/de-serializer (SerDes) that generates the data stream DQ by serializing data that are transmitted through the global input and output lines GIO and that generates data that are output to the global input and output lines GIO by parallelizing the data stream DQ.

FIG. 2 is a diagram illustrating a configuration of a memory cell array 200 according to an embodiment. The memory cell array illustrated in FIG. 1 may include the components of the memory cell array 200. Referring to FIG. 2, the memory cell array 200 may include a first unit cell array MA1, a second unit cell array MA2, and a bit line sense amplifier array SA. The first and second unit cell arrays MA1 and MA2 may each include a plurality of bit lines and a plurality of word lines. A plurality of memory cells may be coupled at points at which the plurality of bit lines and the plurality of word lines cross each other. For example, the first unit cell array MA1 may include at least a first bit line BLT1 and a second bit line BLT2, and the first unit cell array MA1 may include at least a first word line WL1 and a second word line WL2. The second unit cell array MA2 may include at least a first bit line bar BLB1 and a second bit line bar BLB2, and the second unit cell array MA2 may include at least a third word line WLn+1 and a fourth word line WLn+2. The number n may be an integer of 2 or more.

A first memory cell MC1 may be coupled between the first word line WL1 and the first bit line BLT1. The first memory cell MC1 may include a cell transistor ST and a cell capacitor SC. A gate of the cell transistor ST may be coupled to the first word line WL1. One of a drain and source of the cell transistor ST may be coupled to the first bit line BLT1. The other of the drain and source of the cell transistor ST may be coupled to one end of the cell capacitor SC. The other end of the cell capacitor SC may be coupled to a cell plate CP. When the first word line WL1 is enabled, the cell transistor ST is turned on. The cell capacitor SC may be coupled to the first bit line BLT1. When the voltage level of the first bit line BLT1 falls, charges stored in the cell capacitor SC may be discharged, and thus the first memory cell MC1 may store data "0". When the voltage level of the first bit line BLT1 rises, the cell capacitor SC may store charges, and thus the first memory cell MC1 may store data "1".

The bit line sense amplifier array SA may be disposed between the first and second unit cell arrays MA1 and MA2. The bit line sense amplifier array SA may be coupled to the bit lines of the first and second unit cell arrays MA1 and MA2, respectively, and may each perform an amplification operation. The bit line sense amplifier array SA may include a plurality of bit line sense amplifiers. For example, the bit line sense amplifier array SA may include a first bit line sense amplifier BLSA1 and a second bit line sense amplifier BLSA2. The bit line sense amplifier array SA may include the number of bit line sense amplifiers corresponding to the number of bit lines included in the first unit cell array MA1 or the second unit cell array MA2. The first bit line sense amplifier BLSA1 may be coupled to the first bit line BLT1 and the first bit line bar BLB1, and may amplify and latch the voltage levels of the first bit line BLT1 and the first bit line bar BLB1. The second bit line sense amplifier BLSA2 may be coupled to the second bit line BLT2 and the second bit line bar BLB2, and may amplify and latch the voltage levels of the second bit line BLT2 and the second bit line bar BLB2. The first and second bit line sense amplifiers BLSA1 and BLSA2 may include a plurality of transistors that amplify and latch the voltage levels of the first and second bit lines BLT1 and BLT2, respectively, and the first and second bit line bars BLB1 and BLB2, respectively, that are coupled to the first and second bit line sense amplifiers BLSA1 and BLSA2, respectively. The first and second bit line sense amplifiers BLSA1 and BLSA2 may perform mismatch compensation operations that correct a process mismatch or offset between the plurality of transistors before amplifying the voltage levels of the first and second bit lines BLT1 and BLT2 and the first and second bit line bars BLB 1 and BLB2 that are coupled to the first and second bit line sense amplifiers BLSA1 and BLSA2.

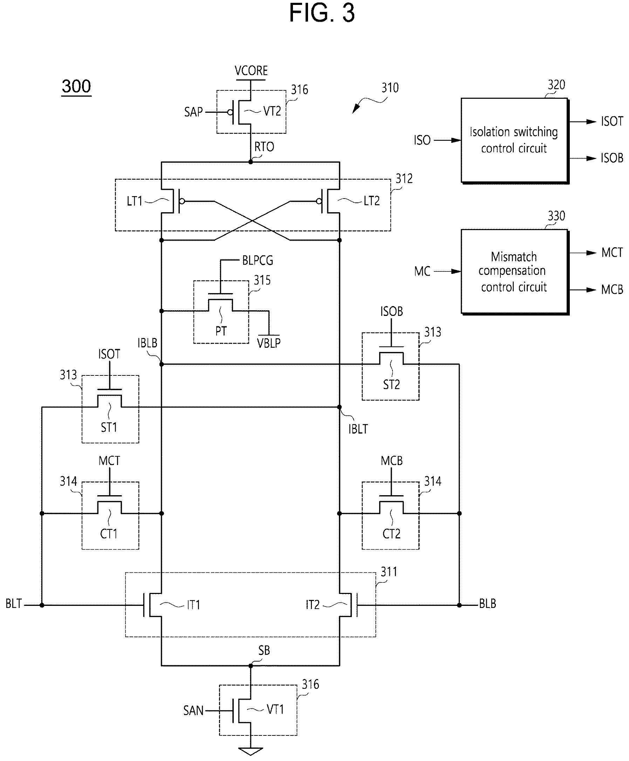

FIG. 3 is a diagram illustrating a configuration of a memory apparatus 300 and a bit line sense amplifier 310 according to an embodiment. Referring to FIG. 3, the bit line sense amplifier 310 may be coupled to a first bit line BLT and a second bit line BLB, and the bit line sense amplifier 310 may amplify the voltage levels of the first and second bit lines BLT and BLB. For example, the first bit line BLT may correspond to the first bit line BLT1 illustrated in FIG. 2, and the second bit line BLB may correspond to the first bit line bar BLB1 illustrated in FIG. 2. The bit line sense amplifier 310 may amplify the voltage levels of the first and second bit lines BLT and BLB to opposite voltage levels by using a core voltage VCORE and a ground voltage. When data stored in a memory cell that is coupled to the first bit line BLT are "0", the bit line sense amplifier 310 may amplify the voltage level of the first bit line BLT to the ground voltage and amplify the voltage level of the second bit line BLB to the voltage level of the core voltage VCORE. When data stored in a memory cell that is coupled to the first bit line BLT are "1", the bit line sense amplifier 310 may amplify the voltage level of the first bit line BLT to the voltage level of the core voltage VCORE and amplify the voltage level of the second bit line BLB to the ground voltage. The bit line sense amplifier 310 may use a plurality of control signals to amplify the voltage levels of the first and second bit lines BLT and BLB.

The bit line sense amplifier 310 may include an input circuit 311, a latch circuit 312, and an isolation switching circuit 313. The input circuit 311 may change the voltage level of a first node IBLB based on the voltage level of the first bit line BLT and change the voltage level of a second node IBLT based on the voltage level of the second bit line BLB. The latch circuit 312 may change the voltage level of the second node IBLT based on the voltage level of the first node IBLB and change the voltage level of the first node IBLB based on the voltage level of the second node IBLT. The isolation switching circuit 313 may receive a first isolation switching signal ISOT and a second isolation switching signal ISOB. The isolation switching circuit 313 may couple the first bit line BLT to the second node IBLT based on the first isolation switching signal ISOT. The isolation switching circuit 313 may couple the second bit line BLB to the first node IBLB based on the second isolation switching signal ISOB. The bit line sense amplifier 310 may further include a mismatch compensation circuit 314 to compensate for the mismatch of a transistor that forms the input circuit 311. The mismatch compensation circuit 314 may receive a first mismatch compensation signal MCT and a second mismatch compensation signal MCB. The mismatch compensation circuit 314 may couple the first bit line BLT to the first node IBLB based on the first mismatch compensation signal MCT and couple the second bit line BLB to the second node IBLT based on the second mismatch compensation signal MCB.

The memory apparatus 300 may further include an isolation switching control circuit 320 and a mismatch compensation control circuit 330. The isolation switching control circuit 320 may receive an isolation switching enable signal ISO, and the isolation switching control circuit 320 may generate the first and second isolation switching signals ISOT and ISOB based on the isolation switching enable signal ISO. For example, the isolation switching enable signal ISO may be generated based on the active signal ACT and the precharge signal PCG illustrated in FIG. 1. When the isolation switching enable signal ISO is disabled, the isolation switching control circuit 320 may disable both the first and second isolation switching signals ISOT and ISOB. When the isolation switching enable signal ISO is enabled, the isolation switching control circuit 320 may enable the first and second isolation switching signals ISOT and ISOB. When the isolation switching enable signal ISO is enabled, the isolation switching control circuit 320 may increase the voltage level of the first isolation switching signal ISOT to the voltage level of an isolation voltage. When the isolation switching enable signal ISO is enabled, the isolation switching control circuit 320 may gradually increase the voltage level of the second isolation switching signal ISOB up to the voltage level of the isolation voltage. For an embodiment, the first isolation switching signal has substantially same voltage level as the isolation voltage when the two voltages are essentially the same aside from manufacturing and operational tolerances of the memory apparatus 300. Accordingly, after the isolation switching enable signal ISO is enabled, the voltage level of the first isolation switching signal ISOT may reach the voltage level of the isolation voltage first, and the voltage level of the second isolation switching signal ISOB may reach the voltage level of the isolation voltage later. For example, the isolation switching control circuit 320 may increase the voltage level of the second isolation switching signal ISOB up to the voltage level of the isolation voltage in two stages. The isolation switching control circuit 320 may increase the voltage level of the second isolation switching signal ISOB from the ground voltage to the voltage level of an intermediate isolation voltage when the isolation switching enable signal ISO is enabled, and may increase the voltage level of the second isolation switching signal ISOB from the voltage level of the intermediate isolation voltage to the voltage level of the isolation voltage after a predetermined time interval elapses. In an embodiment, the isolation switching control circuit 320 may increase the voltage level of the second isolation switching signal ISOB up to the voltage level of the isolation voltage in three or more stages. The isolation switching control circuit 320 can improve performance in that the bit line sense amplifier 310 senses data "1" by gradually increasing the voltage level of the second isolation switching signal ISOB.

The mismatch compensation control circuit 330 may receive a mismatch compensation enable signal MC, and the mismatch compensation control circuit 330 may generate the first mismatch compensation signal MCT and the second mismatch compensation signal MCB based on the mismatch compensation enable signal MC. For example, the mismatch compensation enable signal MC may be generated based on the active signal ACT and the precharge signal PCG. When the mismatch compensation enable signal MC is enabled, the mismatch compensation control circuit 330 may enable both the first and second mismatch compensation signals MCT and MCB. When the mismatch compensation enable signal MC is disabled, the mismatch compensation control circuit 330 may disable both the first and second mismatch compensation signals MCT and MCB. After disabling the second mismatch compensation signal MCB, the mismatch compensation control circuit 330 may disable the first mismatch compensation signal MCT. The mismatch compensation control circuit 330 may disable the second mismatch compensation signal MCB when the mismatch compensation enable signal MC is disabled, and the mismatch compensation control circuit 330 may disable the first mismatch compensation signal MCT after the mismatch compensation enable signal MC and the second mismatch compensation signal MCB are disabled. The mismatch compensation control circuit 330 can improve performance in that the bit line sense amplifier 310 senses data "0" by disabling the first mismatch compensation signal MCT later than the second mismatch compensation signal MCB.

The bit line sense amplifier 310 may further include a precharge circuit 315 and a power supply circuit 316. The precharge circuit 315 may receive a bit line precharge signal BLPCG, and the precharge circuit 315 may drive the first node IBLB to a precharge voltage VBLP based on the bit line precharge signal BLPCG. When the bit line precharge signal BLPCG is enabled, the precharge circuit 315 may set the voltage level of the first node IBLB to the voltage level of the precharge voltage VBLP. The bit line precharge signal BLPCG may be generated based on the active signal ACT and the precharge signal PCG. The power supply circuit 316 may supply a source voltage to the bit line sense amplifier 310 based on a first power control signal SAN and a second power control signal SAP. The power supply circuit 316 may supply a low voltage to a first power terminal SB of the bit line sense amplifier 310 based on the first power control signal SAN, and the power supply circuit 316 may supply a high voltage to a second power terminal RTO of the bit line sense amplifier 310 based on the second power control signal SAP. For example, the low voltage may be the ground voltage, and the high voltage may be the core voltage VCORE.

The input circuit 311 may include a first input transistor IT1 and a second input transistor IT2. The first input transistor IT1 may couple the first node IBLB to the first power terminal SB based on the voltage level of the first bit line BLT. The second input transistor IT2 may couple the second node IBLT to the first power terminal SB based on the voltage level of the second bit line BLB. The first and second input transistors IT1 and IT2 may each be an N channel MOS transistor. A gate of the first input transistor IT1 may be coupled to the first bit line BLT. A drain of the first input transistor IT1 may be coupled to the first node IBLB. A source of the first input transistor IT1 may be coupled to the first power terminal SB. A gate of the second input transistor IT2 may be coupled to the second bit line BLB. A drain of the second input transistor IT2 may be coupled to the second node IBLT. A source of the second input transistor IT2 may be coupled to the first power terminal SB.

The latch circuit 312 may include a first latch transistor LT1 and a second latch transistor LT2. The first latch transistor LT1 may change the voltage level of the first node IBLB based on the voltage level of the second node IBLT. The second latch transistor LT2 may change the voltage level of the second node IBLT based on the voltage level of the first node IBLB. The first and second latch transistors LT1 and LT2 may each be a P channel MOS transistor. A gate of the first latch transistor LT1 may be coupled to the second node IBLT. A source of the first latch transistor LT1 may be coupled to the second power terminal RTO. A drain of the first latch transistor LT1 may be coupled to the first node IBLB. A gate of the second latch transistor LT2 may be coupled to the first node IBLB. A source of the second latch transistor LT2 may be coupled to the second power terminal RTO. A drain of the second latch transistor LT2 may be coupled to the second node IBLT.

The isolation switching circuit 313 may include a first isolation transistor ST1 and a second isolation transistor ST2. The first isolation transistor ST1 may couple the first bit line BLT and the second node IBLT based on the first isolation switching signal ISOT. The second isolation transistor ST2 may couple the second bit line BLB and the first node IBLB based on the second isolation switching signal ISOB. The first and second isolation transistors ST1 and ST2 may each include an N channel MOS transistor. A gate of the first isolation transistor ST1 may receive the first isolation switching signal ISOT. One of a drain and source of the first isolation transistor ST1 may be coupled to the first bit line BLT. The other of the drain and source of the first isolation transistor ST1 may be coupled to the second node IBLT. A gate of the second isolation transistor ST2 may receive the second isolation switching signal ISOB. One of a drain and source of the second isolation transistor ST2 may be coupled to the second bit line BLB. The other of the drain and source of the second isolation transistor ST2 may be coupled to the first node IBLB.

The mismatch compensation circuit 314 may include a first compensation transistor CT1 and a second compensation transistor CT2. The first compensation transistor CT1 may couple the first bit line BLT and the first node IBLB based on the first mismatch compensation signal MCT. The second compensation transistor CT2 may couple the second bit line BLB and the second node IBLT based on the second mismatch compensation signal MCB. The first and second compensation transistors CT1 and CT2 may each be an N channel MOS transistor. A gate of the first compensation transistor CT1 may receive the first mismatch compensation signal MCT. One of a drain and source of the first compensation transistor CT1 may be coupled to the first bit line BLT. The other of the drain and source of the first compensation transistor CT1 may be coupled to the first node IBLB. A gate of the second compensation transistor CT2 may receive the second mismatch compensation signal MCB. One of a drain and source of the second compensation transistor CT2 may be coupled to the second bit line BLB. The other of the drain and source of the second compensation transistor CT2 may be coupled to the second node IBLT.

The precharge circuit 315 may include a precharge transistor PT. The precharge transistor PT may apply the precharge voltage VBLP to the first node IBLB based on the bit line precharge signal BLPCG. The precharge transistor PT may be an N channel MOS transistor. A gate of the precharge transistor PT may receive the bit line precharge signal BLPCG. One of a drain and source of the precharge transistor PT may receive the precharge voltage VBLP. The other of the drain and source of the precharge transistor PT may be coupled to the first node IBLB.

The power supply circuit 316 may include a first supply transistor VT1 and a second supply transistor VT2. The first supply transistor VT1 may couple the first power terminal SB to the ground voltage based on the first power control signal SAN. The second supply transistor VT2 may apply the core voltage VCORE to the second power terminal RTO based on the second power control signal SAP. The first and second supply transistors VT1 and VT2 may each be an N channel MOS transistor. A gate of the first supply transistor VT1 may receive the first power control signal SAN. A drain of the first supply transistor VT1 may be coupled to the first power terminal SB. A source of the first supply transistor VT1 may be coupled to the ground voltage. A gate of the second supply transistor VT2 may receive the second power control signal SAP. A drain of the second supply transistor VT2 may receive the core voltage VCORE. A source of the second supply transistor VT2 may be coupled to the second power terminal RTO.

When the second isolation switching signal ISOB has a lower voltage level than the first isolation switching signal ISOT, that is, the first isolation switching signal ISOT is enabled to the voltage level of the isolation voltage and the second isolation switching signal ISOB is enabled to the voltage level of the intermediate isolation voltage, the bit line sense amplifier 310 may amplify the first and second bit lines BLT and BLB. The first isolation transistor ST1 is fully turned on in response to the first isolation switching signal ISOT. In contrast, the second isolation transistor ST2 may be partially turned on in response to the second isolation switching signal ISOB. Accordingly, a load of the first node IBLB may be relatively smaller than a load of the second node IBLT. At this time, when data "1" are stored in a memory cell that is coupled to the first bit line BLT, the voltage level of the first node IBLB may fall to the ground voltage more rapidly by the first input transistor IT1 because the load of the first node IBLB is small. When the voltage level of the first node IBLB rapidly falls, the voltage level of the second node IBLT may rise to the voltage level of the core voltage VCORE more rapidly by the second latch transistor LT2. Accordingly, when the voltage level of the second isolation switching signal ISOB is gradually increased to the voltage level of the isolation voltage, performance in that the bit line sense amplifier 310 senses data "1" can be improved.

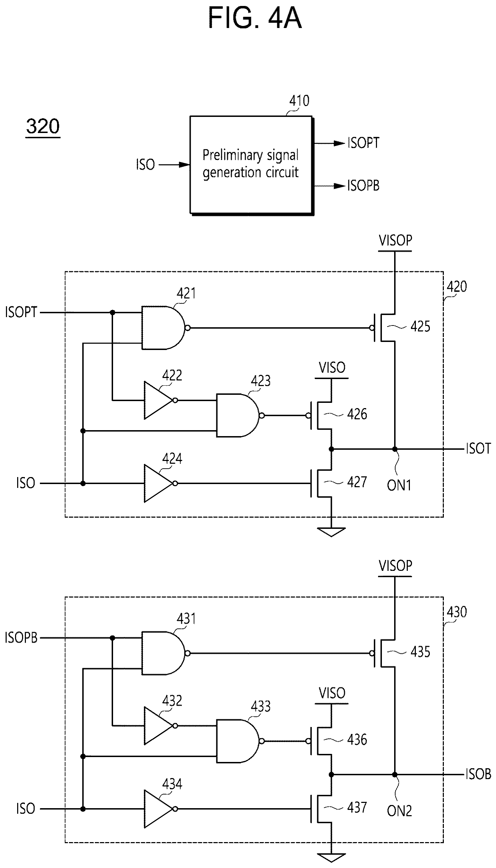

FIG. 4A is a diagram illustrating a configuration of the isolation switching control circuit 320 illustrated in FIG. 3. Referring to FIG. 4A, the isolation switching control circuit 320 may include a preliminary signal generation circuit 410, a first isolation switching enable circuit 420, and a second isolation switching enable circuit 430. The preliminary signal generation circuit 410 may receive the isolation switching enable signal ISO and generate a first preliminary isolation signal ISOPT and a second preliminary isolation signal ISOPB. The preliminary signal generation circuit 410 may generate the first preliminary isolation signal ISOPT regardless of the isolation switching enable signal ISO. For example, the preliminary signal generation circuit 410 may generate the first preliminary isolation signal IOSPT that maintains the state in which the first preliminary isolation signal IOSPT has been disabled to a logic low level. The preliminary signal generation circuit 410 may generate the second preliminary isolation signal ISOPB based on the isolation switching enable signal ISO. The preliminary signal generation circuit 410 may generate the second preliminary isolation signal IOSPB that is enabled for a predetermined time interval from when the isolation switching enable signal ISO is enabled. The preliminary signal generation circuit 410 may enable the second preliminary isolation signal ISOPB when the isolation switching enable signal ISO is enabled, and the preliminary signal generation circuit 410 may disable the second preliminary isolation signal ISOPB when the second preliminary isolation signal ISOPB is enabled and the predetermined time interval elapses. The predetermined time interval may be a time interval during which the voltage level of the second isolation switching signal ISOB gradually increases, and the predetermined time interval may be arbitrarily set. In an embodiment, the preliminary signal generation circuit 410 may be modified to generate only the second preliminary isolation switching signal ISOPB.

The first isolation switching enable circuit 420 may receive the first preliminary isolation signal ISOPT and the isolation switching enable signal ISO, and the first isolation switching enable circuit 420 may generate the first isolation switching signal ISOT based on the first preliminary isolation signal ISOPT and the isolation switching enable signal ISO. The first isolation switching enable circuit 420 may receive the first preliminary isolation signal ISOPT as a dummy signal. The first isolation switching enable circuit 420 may drive the first isolation switching signal ISOT to the voltage level of an isolation voltage VISO based on the isolation switching enable signal ISO. When the isolation switching enable signal ISO is enabled, the first isolation switching enable circuit 420 may enable the first isolation switching signal ISOT by driving the first isolation switching signal ISOT to the voltage level of the isolation voltage VISO. When the isolation switching enable signal ISO is disabled, the first isolation switching enable circuit 420 may disable the first isolation switching signal ISOT by dropping the first isolation switching signal ISOT to the ground voltage.

The second isolation switching enable circuit 430 may receive the second preliminary isolation signal ISOPB and the isolation switching enable signal ISO, and the second isolation switching enable circuit 430 may generate the second isolation switching signal ISOB based on the second preliminary isolation signal ISOPB and the isolation switching enable signal ISO. The second isolation switching enable circuit 430 may drive the second isolation switching signal ISOB to the voltage level of an intermediate isolation voltage VISOP and the voltage level of the isolation voltage VISO based on the second preliminary isolation signal ISOPB and the isolation switching enable signal ISO. When the isolation switching enable signal ISO and the second preliminary isolation signal ISOPB are enabled, the second isolation switching enable circuit 430 may partially enable the second isolation switching signal ISOB by driving the second isolation switching signal ISOB to the voltage level of the intermediate isolation voltage VISOP. When the second preliminary isolation signal ISOPB is disabled in the state in which the isolation switching enable signal ISO has been enabled, the second isolation switching enable circuit 430 may fully enable the second isolation switching signal ISOB by driving the second isolation switching signal ISOB to the voltage level of the isolation voltage VISO. When the isolation switching enable signal ISO is disabled, the second isolation switching enable circuit 430 may disable the second isolation switching signal ISOB by dropping the second isolation switching signal ISOB to the ground voltage.

The first isolation switching enable circuit 420 may include a first NAND gate 421, a first inverter 422, a second NAND gate 423, a second inverter 424, a first transistor 425, a second transistor 426, and a third transistor 427. The first NAND gate 421 may receive the first preliminary isolation signal ISOPT and the isolation switching enable signal ISO. The first inverter 422 may invert the first preliminary isolation signal ISOPT. The second NAND gate 423 may receive the output signal of the first inverter 422 and the isolation switching enable signal ISO. The second inverter 424 may invert the isolation switching enable signal ISO. The first transistor 425 may be a P channel MOS transistor. A gate of the first transistor 425 may receive the output signal of the first NAND gate 421. A source of the first transistor 425 may receive the intermediate isolation voltage VISOP. A drain of the first transistor 425 may be coupled to a first output node ON1. The first isolation switching signal ISOT may be output from the first output node ON1. The second transistor 426 may be a P channel MOS transistor. A gate of the second transistor 426 may receive the output signal of the second NAND gate 423. A source of the second transistor 426 may receive the isolation voltage VISO. A drain of the second transistor 426 may be coupled to the first output node ON1. The third transistor 427 may be an N channel MOS transistor. A gate of the third transistor 427 may receive the output signal of the second inverter 424. A drain of the third transistor 427 may be coupled to the first output node ON1. A source of the third transistor 427 may be coupled to the ground voltage.

The second isolation switching enable circuit 430 may include a first NAND gate 431, a first inverter 432, a second NAND gate 433, a second inverter 434, a first transistor 435, a second transistor 436, and a third transistor 437. The first NAND gate 431 may receive the second preliminary isolation signal ISOPB and the isolation switching enable signal ISO. The first inverter 432 may invert the second preliminary isolation signal ISOPB. The second NAND gate 433 may receive the output signal of the first inverter 432 and the isolation switching enable signal ISO. The second inverter 434 may invert the isolation switching enable signal ISO. The first transistor 435 may be a P channel MOS transistor. A gate of the first transistor 435 may receive the output signal of the first NAND gate 431. A source of the first transistor 435 may receive the intermediate isolation voltage VISOP. A drain of the first transistor 435 may be coupled to a second output node ON2. The second isolation switching signal ISOB may be output from the second output node ON2. The second transistor 436 may be a P channel MOS transistor. A gate of the second transistor 436 may receive the output signal of the second NAND gate 433. A source of the second transistor 436 may receive the isolation voltage VISO. A drain of the second transistor 436 may be coupled to the second output node ON2. The third transistor 437 may be an N channel MOS transistor. A gate of the third transistor 437 may receive the output signal of the second inverter 434. A drain of the third transistor 437 may be coupled to the second output node ON2. A source of the third transistor 437 may be coupled to the ground voltage.

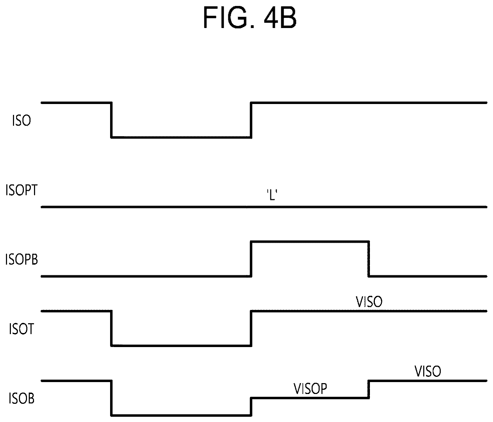

FIG. 4B is a timing diagram illustrating an operation of the isolation switching control circuit 320 illustrated in FIG. 4A. Referring to FIGS. 4A and 4B, when the isolation switching enable signal ISO is disabled, the third transistors 427 and 437 of the first and second isolation switching enable circuits 420 and 430 may be turned on, and both the first and second isolation switching signals ISOT and ISOB may be disabled to a logic low level. The preliminary signal generation circuit 410 may continue to maintain the first preliminary isolation signal ISOPT to a logic low level regardless of the isolation switching enable signal ISO. When the isolation switching enable signal ISO is enabled, the preliminary signal generation circuit 410 may enable the second preliminary isolation signal ISOPB for a predetermined time interval. When the isolation switching enable signal ISO is enabled, the second transistor 426 of the first isolation switching enable circuit 420 may be turned on. The first isolation switching enable circuit 420 may enable the first isolation switching signal ISOT by raising the first isolation switching signal ISOT to the voltage level of the isolation voltage VISO. When the second preliminary isolation signal ISOPB is enabled, the second transistor 436 of the second isolation switching enable circuit 430 may be turned off and the first transistor 435 may be turned on. The second isolation switching enable circuit 430 may partially enable the second isolation switching signal ISOB by raising the second isolation switching signal ISOB to the voltage level of the intermediate isolation voltage VISOP. When the second preliminary isolation signal ISOPB is disabled, the first transistor 435 may be turned off and the second transistor 436 may be turned on. The second isolation switching enable circuit 430 may fully enable the second isolation switching signal ISOB by raising the second isolation switching signal ISOB to the voltage level of the isolation voltage VISO.

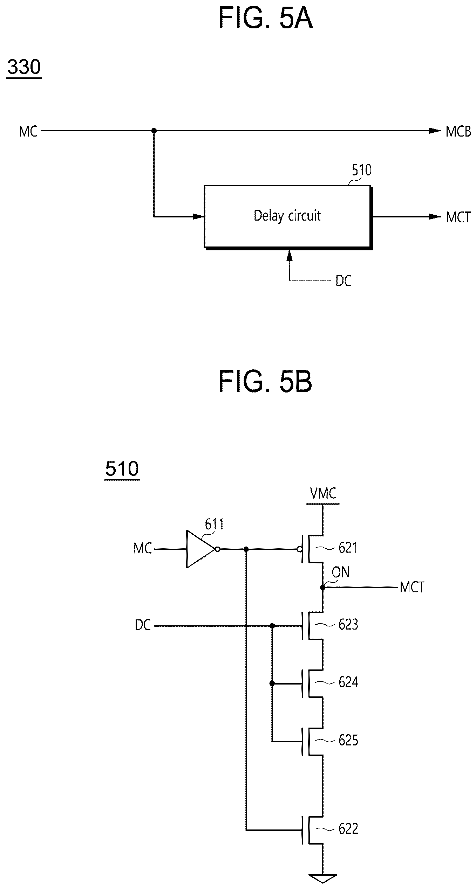

FIG. 5A is a diagram illustrating a configuration of the mismatch compensation control circuit 330 illustrated in FIG. 3. Referring to FIG. 5A, the mismatch compensation control circuit 330 may include a delay circuit 510. The mismatch compensation control circuit 330 may receive the mismatch compensation enable signal MC, and the mismatch compensation control circuit 330 may output the mismatch compensation enable signal MC as the second mismatch compensation signal MCB without separate delay. The delay circuit 510 may receive the mismatch compensation enable signal MC, and the delay circuit 510 may generate the first mismatch compensation signal MCT by delaying the mismatch compensation enable signal MC. The delay circuit 510 may receive the delay control signal DC, and the delay circuit 510 may change a delay time interval for the mismatch compensation enable signal MC based on the delay control signal DC. The delay control signal DC may be an analog signal having various voltage levels, or the delay control signal DC may be a digital signal including a plurality of bits. The delay time interval of the delay circuit 510 may be varied based on the delay control signal DC. The delay circuit 510 may be provided to disable the first mismatch compensation signal MCT later than the second mismatch compensation signal MCB. The delay time interval of the delay circuit 510 may be arbitrarily set.

FIG. 5B is a diagram illustrating a configuration of the delay circuit 510 illustrated in FIG. 5A. Referring to FIG. 5B, the delay circuit 510 may include an inverter 611, a first transistor 621, a second transistor 622, a third transistor 623, a fourth transistor 624, and a fifth transistor 625. The inverter 611 may receive the mismatch compensation enable signal MC and invert the mismatch compensation enable signal MC. The first transistor 621may be a P channel MOS transistor. A gate of the first transistor 621 may receive the output signal of the inverter 611. A source of the first transistor 621 may receive a mismatch compensation voltage VMC. A drain of the first transistor 621 may be coupled to an output node ON. The first mismatch compensation signal MCT may be output from the output node ON. The second transistor 622 may be an N channel MOS transistor. A gate of the second transistor 622 may receive the output signal of the inverter 611. A source of the second transistor 622 may be coupled to the ground voltage. The third to fifth transistors 623, 624, and 625 may each be an N channel MOS transistor. The third to fifth transistors 623, 624, and 625 may be coupled in series between the output node ON and the second transistor 622. A gate of the third transistor 623 may receive the delay control signal DC. A drain of the third transistor 623 may be coupled to the output node ON. A gate of the fourth transistor 624 may receive the delay control signal DC. A drain of the fourth transistor 624 may be coupled to a source of the third transistor 623. A gate of the fifth transistor 625 may receive the delay control signal DC. A drain of the fifth transistor 625 may be coupled to a source of the fourth transistor 624. A source of the fifth transistor 625 may be coupled to a drain of the second transistor 622. When the mismatch compensation enable signal MC is in a logic high level, the first transistor 621 may be turned on, and the first mismatch compensation signal MCT may be driven to the voltage level of the mismatch compensation voltage VMC. When the mismatch compensation enable signal MC transitions from a logic high level to a logic low level, the second transistor 622 may be turned on and the voltage level of the first mismatch compensation signal MCT may fall the mismatch compensation voltage VMC to the ground voltage. At this time, the transition slope of the first mismatch compensation signal MCT may be changed depending on the voltage level of the delay control signal DC. As the voltage level of the delay control signal DC rises, the transition slope of the first mismatch compensation signal MCT may be increased, and the timing at which the first mismatch compensation signal MCT is disabled may become fast because the current driving forces of the third to fifth transistors 623, 624, and 625 become strong. As the voltage level of the delay control signal DC falls, the transition slope of the first mismatch compensation signal MCT may be reduced, and the timing at which the first mismatch compensation signal CMT is disabled may become slow because the current driving forces of the third to fifth transistors 623, 624, and 625 become weak.

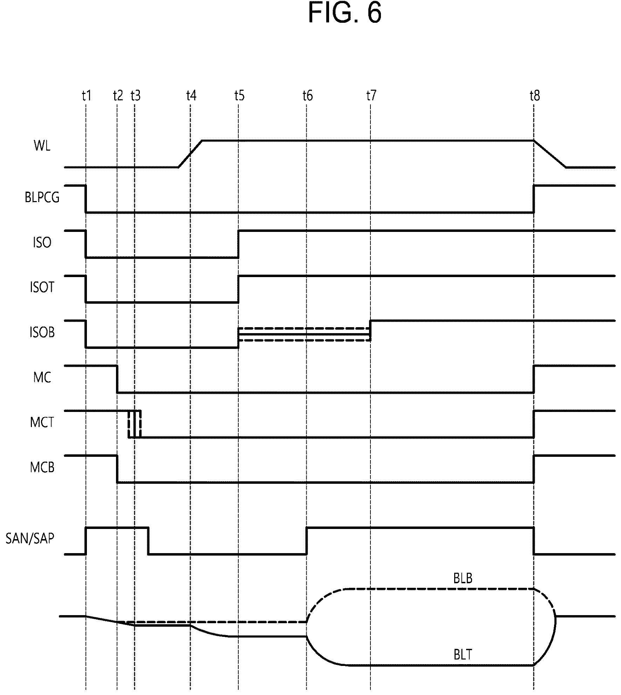

FIG. 6 is a timing diagram illustrating operations of the memory apparatus 300 and the bit line sense amplifier 310 according to an embodiment. The operations of the memory apparatus 300 and the bit line sense amplifier 310 according to an embodiment are described as follows with reference to FIGS. 1 to 6. Prior to time t1, the bit line precharge signal BLPCG, the isolation switching enable signal ISO, the first isolation switching signal ISOT, the second isolation switching signal ISOB, the mismatch compensation enable signal MC, the first mismatch compensation signal MCT, and the second mismatch compensation signal MCB may be in an enabled state, and the first power control signal SAN and the second power control signal SAP may be in a disabled state. An interval prior to time t1 may be a precharge operation interval of the bit line sense amplifier 310. During the interval prior to time t1, all of the voltage levels of the first node IBLB, the second node IBLT, the first bit line BLT, and the second bit line BLB may be precharged to the voltage level of the precharge voltage VBLP. At time t1, the bit line precharge signal BLPCG, the isolation switching enable signal ISO, the first isolation switching signal ISOT, and the second isolation switching signal ISOB may be disabled. The first mismatch compensation signal MCT and the second mismatch compensation signal MCB may maintain the enabled state. The first power control signal SAN and the second power control signal SAP may be enabled. The first and second isolation transistors ST1 and ST2 may be turned off. The first compensation transistor CT1 may couple the first bit line BLT and the first node IBLB. The second compensation transistor CT2 may couple the second bit line BLB and the second node IBLT. The first supply transistor VT1 may couple the first power terminal SB to the ground voltage. The second supply transistor VT2 may apply the core voltage VCORE to the second power terminal RTO. As the source voltage is supplied to the first and second power terminals SB and RTO, a current may flow from the first and second nodes IBLB and IBLT to the second power terminal SB through the first and second input transistors IT1 and IT2. The voltage levels of the first bit line BLT and the second bit line BLB may slowly fall from the voltage level of the precharge voltage VBLP. At this time, when a process skew is present between the first and second input transistors IT1 and IT2, the voltage levels of the first and second nodes IBLB and IBLT may fall at different slopes due to a difference between the threshold voltages of the first and second input transistors IT1 and IT2. At time t2, the mismatch compensation enable signal MC may be disabled. The mismatch compensation control circuit 330 may disable the second mismatch compensation signal MCB. At time t3, the mismatch compensation control circuit 330 may disable the first mismatch compensation signal MCT. As indicated by a dashed line, the timing at which the first mismatch compensation signal MCT is disabled may be variously adjusted by varying the delay time interval of the delay circuit 510. An interval from time t2 to time t3 may correspond to the delay time interval of the delay circuit 510 of the mismatch compensation control circuit 330. At time t2, as the second compensation transistor CT2 is turned off, the voltage level of the second bit line BLB may no longer fall between time t2 and time t3. The voltage level of the first bit line BLT may additionally fall because the first compensation transistor CT1 maintains a turn-on state between time t2 and time t3. An interval from time t1 to time t3 may be a mismatch compensation operation interval of the bit line sense amplifier 310. The mismatch compensation control circuit 330 may additionally drop the voltage level of the first bit line BLT during the interval from time t2 to time t3 by disabling the first mismatch compensation signal MCT later than the second mismatch compensation signal MCB. Accordingly, performance in that the bit line sense amplifier 310 senses data "0" can be improved. The first and second power control signals SAN and SAP may be disabled at arbitrary timing after time t3. In an embodiment, the first and second power control signals SAN and SAP may be disabled at the same timing. In an embodiment, to improve performance in that the bit line sense amplifier 310 senses data "1", the first power control signal SAN may be disabled earlier than the second power control signal SAP. In an embodiment, to improve performance in that the bit line sense amplifier 310 senses data "0", the second power control signal SAP may be disabled earlier than the first power control signal SAN.

At time t4, a word line WL may be enabled based on the active signal ACT and the row address signal RADD. When the word line WL is enabled, the first bit line BLT may be coupled to a memory cell, and a charge sharing operation between the first bit line BLT and the memory cell may be performed. As illustrated in FIG. 6, when data stored in the memory cell are "0", the voltage level of the first bit line BLT may additionally fall. When data stored in the memory cell are "1 ", the voltage level of the first bit line BLT may rise, and the voltage level of the first bit line BLT may become higher than the voltage level of the second bit line BLB. At time t5, the isolation switching enable signal ISO may be enabled. An interval from time t4 to time t5 may be a charge sharing operation interval. At time t5, the isolation switching control circuit 320 fully enables the first isolation switching signal ISOT to the voltage level of the isolation voltage VISO, whereas the isolation switching control circuit 320 may partially enable the second isolation switching signal ISOB to the voltage level of the intermediate isolation voltage VISOP. As illustrated by a dashed line, the voltage level of the second isolation switching signal ISOB may be variously adjusted by variously changing the voltage level of the intermediate isolation voltage VISOP. At time t6, the first and second power control signals SAN and SAP may be enabled, and the source voltage may be applied to the first and second power terminals SB and RTO. An interval after t6 may be a sensing interval of the bit line sense amplifier 310. The bit line sense amplifier 310 may drop the voltage levels of the first bit line BLT and the second node IBLT to the ground voltage and increase the voltage levels of the second bit line BLB and the first node IBLB to the core voltage level VOCRE by amplifying the voltage levels of the first and second bit lines BLT and BLB. The first latch transistor LT1 may maintain the voltage level of the first node IBLB at the voltage level of the core voltage VCORE by applying the core voltage VCORE to the first node IBLB based on the voltage level of the second node IBLT. In contrast, when data stored in the memory cell are "1", the bit line sense amplifier 310 may increase the voltage levels of the first bit line BLT and the second node IBLT to the voltage level of the core voltage VCORE and drop the voltage levels of the second bit line BLB and the first node IBLB to the ground voltage by amplifying the voltage levels of the first and second bit lines BLT and BLB. At this time, in response to the second isolation switching signal ISOB, the second isolation transistor ST2 may be partially turned on, and the voltage level of the first node IBLB may drop to the ground voltage more rapidly. In response to the voltage level of the first node IBLB, the second latch transistor LT2 may increase the voltage level of the second node IBLT to the voltage level of the core voltage VCORE more rapidly.

At time t7, the isolation switching control circuit 320 may increase the second isolation switching signal ISOB to the voltage level of the isolation voltage VISO, and the isolation switching control circuit 320 may fully enable the second isolation switching signal ISOB. During an interval after time t7, the bit line sense amplifier 310 may perform a read operation and a write operation based on the read signal RD and the write signal WT. At time t8, the word line WL may be disabled based on the precharge signal PCG. The bit line precharge signal BLPCG, the mismatch compensation enable signal MC, the first mismatch compensation signal MCT, and the second mismatch compensation signal MCB may be enabled. The first and second power control signals SAN and SAP may be disabled. The first and second bit lines BLT and BLB may be precharged to the voltage level of the precharge voltage VBLP.

Those skilled in the art to which the present disclosure pertains will understand that the present disclosure may be implemented in various other ways without departing from the technical spirit or characteristics of the present technology. Accordingly, it is to be understood that the aforementioned embodiments are illustrative in all aspects and not limiting. The scope of the present technology is defined by the appended claims rather than by the detailed description, and all modifications or variations derived from the meanings and scope of the claims and equivalents thereof should be understood as being included in the scope of the present technology.

## Claims

1. A memory apparatus comprising:
an input circuit configured to change a voltage level of a first node based on a voltage level of a first bit line and to change a voltage level of a second node based on a voltage level of a second bit line;
a latch circuit configured to change the voltage level of the second node based on the voltage level of the first node and to change the voltage level of the first node based on the voltage level of the second node;
an isolation switching circuit configured to couple the first bit line to the second node based on a first isolation switching signal and to couple the second bit line to the first node based on a second isolation switching signal; and
an isolation switching control circuit configured to increase a voltage level of the first isolation switching signal to a voltage level of an isolation voltage and to gradually increase a voltage level of the second isolation switching signal to the voltage level of the isolation voltage, when an isolation switching enable signal is enabled.

2. The memory apparatus of claim 1, wherein the second isolation switching signal reaches the voltage level of the isolation voltage after the first isolation switching signal reaches the voltage level of the isolation voltage.

3. The memory apparatus of claim 1, wherein the input circuit comprises:
a first input transistor configured to couple the first node to a first power node based on the voltage level of the first bit line; and
a second input transistor configured to couple the second node to the first power node based on the voltage level of the second bit line.

4. The memory apparatus of claim 3, wherein the latch circuit comprises:
a first latch transistor configured to couple a second power node to the first node based on the voltage level of the second node; and
a second latch transistor configured to couple the second power node to the second node based on the voltage level of the first node.

5. The memory apparatus of claim 4, wherein the isolation switching circuit comprises:
a first isolation transistor configured to couple the first bit line to the second node based on the first isolation switching signal; and
a second isolation transistor configured to couple the second bit line to the first node based on the second isolation switching signal.

6. The memory apparatus of claim 5, further comprising a power supply circuit configured to couple the first power node to a ground voltage based on a first power control signal and to apply a core voltage to the second power node based on a second power control signal.

7. The memory apparatus of claim 6, wherein the first and second power control signals are enabled when the first isolation switching signal has substantially the same voltage level as the isolation voltage and the second isolation switching signal has a lower voltage level than the isolation voltage.

8. The memory apparatus of claim 1, wherein the isolation switching control circuit is configured:
to increase the first isolation switching signal to the voltage level of the isolation voltage and to increase the second isolation switching signal to a voltage level of an intermediate isolation voltage, when the isolation switching enable signal is enabled; and
to increase the second isolation switching signal to the voltage level of the isolation voltage after a predetermined time interval.

9. The memory apparatus of claim 1, wherein the isolation switching control circuit comprises:
a preliminary signal generation circuit configured to generate a preliminary isolation signal that is enabled for a predetermined time interval from when the isolation switching enable signal is enabled;
a first isolation switching enable circuit configured to drive the first isolation switching signal to the voltage level of the isolation voltage based on the isolation switching enable signal; and
a second isolation switching enable circuit configured to drive the second isolation switching signal to a voltage level of an intermediate isolation voltage and the voltage level of the isolation voltage based on the isolation switching enable signal and the preliminary isolation signal.

10. The memory apparatus of claim 9, wherein the second isolation switching enable circuit is configured:
to drive the second isolation switching signal to the voltage level of the intermediate isolation voltage when the isolation switching enable signal and the preliminary isolation signal are enabled; and
to drive the second isolation switching signal to the voltage level of the isolation voltage when the isolation switching enable signal is enabled and the preliminary isolation signal is disabled.

11. The memory apparatus of claim 1, further comprising a mismatch compensation circuit configured to couple the first bit line to the first node based on a first mismatch compensation signal and to couple the second bit line to the second node based on a second mismatch compensation signal.

12. The memory apparatus of claim 11, further comprising a mismatch compensation control circuit configured to generate the first and second mismatch compensation signals based on a mismatch compensation enable signal and to disable the first mismatch compensation signal after disabling the second mismatch compensation signal.

13. The memory apparatus of claim 11, further comprising a mismatch compensation control circuit configured to output a mismatch compensation enable signal as the first mismatch compensation signal and to generate the second mismatch compensation signal by delaying the mismatch compensation enable signal.

14. The memory apparatus of claim 11, wherein the mismatch compensation circuit comprises:
a first compensation transistor configured to couple the first bit line to the first node based on the first mismatch compensation signal; and
a second compensation transistor configured to couple the second bit line to the second node based on the second mismatch compensation signal.

15. A memory apparatus comprising:
an input circuit configured to change a voltage level of a first node based on a voltage level of a first bit line and to change a voltage level of a second node based on a voltage level of a second bit line;
a latch circuit configured to change the voltage level of the second node based on the voltage level of the first node and to change the voltage level of the first node based on the voltage level of the second node;
an isolation switching circuit configured to couple the first bit line to the second node based on a first isolation switching signal and to couple the second bit line to the first node based on a second isolation switching signal; and
a mismatch compensation circuit configured to couple the first bit line to the first node based on a first mismatch compensation signal and to couple the second bit line to the second node based on a second mismatch compensation signal.
